(19) Europäisches Patentamt
European Patent Office
Office européen des brevets

(11) **EP 0 740 073 B1**

## (12) EUROPEAN PATENT SPECIFICATION

(45) Date of publication and mention
of the grant of the patent:
**18.08.2004 Bulletin 2004/34**

(51) Int Cl.[7]: **F02P 17/12**, G01R 29/027,
G01R 31/38

(21) Application number: **95830168.1**

(22) Date of filing: **28.04.1995**

(54) **Circuit for detecting an overvoltage on an electric load**

Schaltung zur Erkennung einer Überspannung an einem elektrischen Verbraucher

Circuit pour détecter une surtension dans un charge électrique

(84) Designated Contracting States:
**DE FR GB IT**

(43) Date of publication of application:
**30.10.1996 Bulletin 1996/44**

(73) Proprietors:
• **CO.RI.M.ME.**
**CONSORZIO PER LA RICERCA SULLA**
**MICROELETTRONICA NEL MEZZOGIORNO**
**95121 Catania (IT)**
• **STMicroelectronics S.r.l.**
**20041 Agrate Brianza (Milano) (IT)**

(72) Inventors:
• **Palara, Sergio**
**I-95026 Acitrezza (Catania) (IT)**

• **Sueri, Stefano**
**I-95100 Catania (IT)**
• **Schiaccianoce, Salvatore**
**I-95018 Riposto (Catania) (IT)**

(74) Representative: **Botti, Mario**
**Botti & Ferrari S.r.l.,**
**Via Locatelli, 5**
**20124 Milano (IT)**

(56) References cited:
**EP-A- 0 020 068      EP-A- 0 386 431**
**EP-A- 0 502 549**

**Description**

This invention relates to a circuit for detecting overvoltage on an electrical load inserted between a feed line and a controlled switch.

The field of application of the invention relates in particular to the motor vehicle industry and the description which follows is made with reference to a circuit to detect an overvoltage in a coil inserted between a feed line and a controlled switch, solely for the purpose of simplifying the description.

It is known that in an electronic ignition device for an internal combustion engine it is necessary to detect whether a spark in the secondary circuit of an ignition coil included in the device is present or absent during the exhaust stage.

If a spark is in fact absent it is necessary to perform subsequent actions in order to avoid deterioration of the catalytic converter.

A known technical arrangement for meeting this need is described in European Patent Application EP-A-0 344 349, which suggests that the present or absence of a spark in the secondary circuit of the engine's ignition coil should be detected by examining the different behaviour of the voltage present in the primary circuit of the coil.

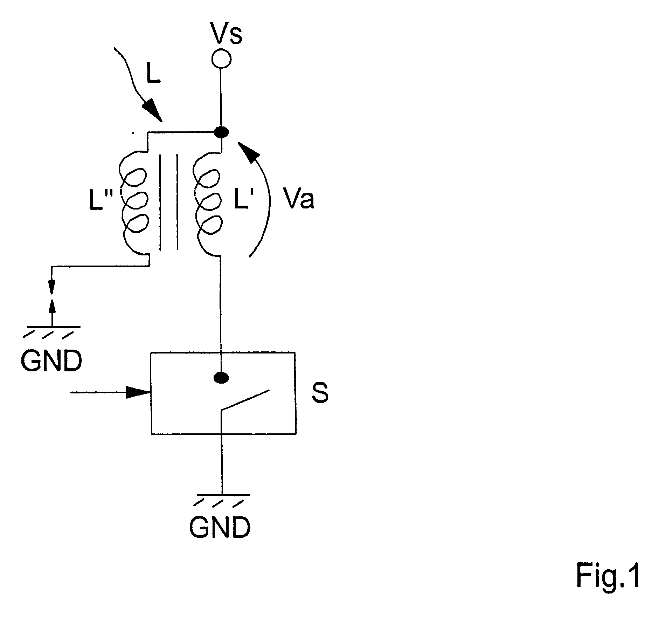

For a better understanding of this phenomenon we refer to Figure 1.

When a control switch S included in the electronic ignition device of an internal combustion engine closes, a current which increases linearly with time passes through the primary circuit L' of the ignition coil L.

If on the other hand control switch S opens, voltage Va present in the primary circuit L' of ignition coil L increases rapidly and then stops, after a certain time interval, at a value equal to that of the voltage Vs provided by the vehicle's battery.

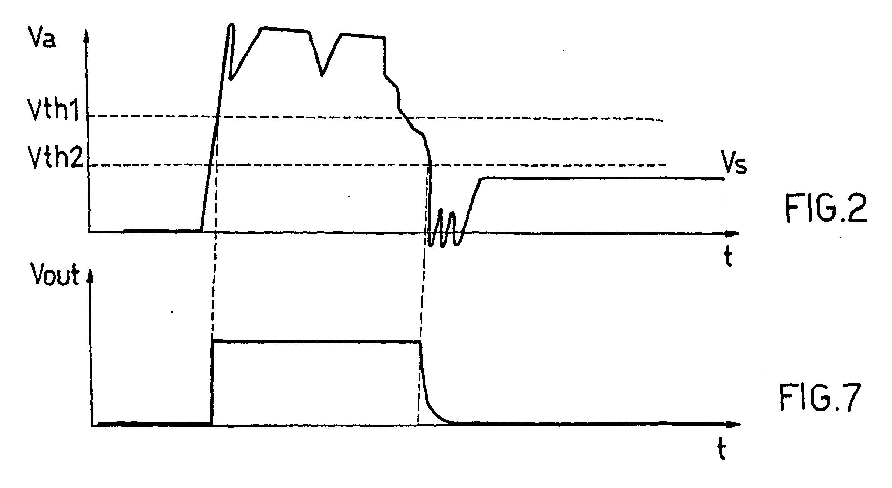

In the latter case it is possible to detect that the behaviour of voltage Va is approximately that shown in Figure 2 if there is no spark in the secondary circuit L" of ignition coil L.

In this first situation the time for which the overvoltage lasts is approximately 100 µs.

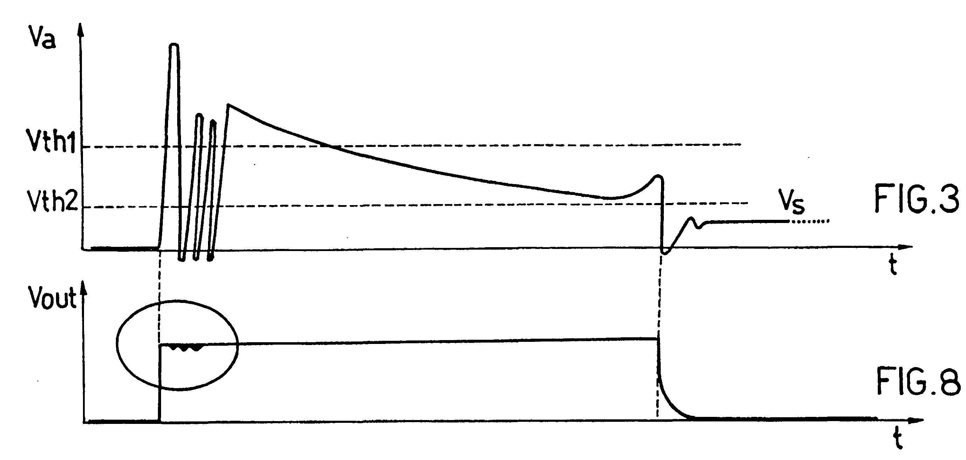

If on the other hand there is a spark in the secondary circuit L" of ignition coil L, the behaviour of voltage Va is that shown in Figure 3.

In this latter situation the overvoltage lasts approximately 2 ms.

The technical problem underlying this invention is that of providing a circuit for correct and accurate determination of a time duration of an overvoltage on an electrical load between a feed line and a controlled switch.

The technical problem is solved by a circuit of the abovementioned type as defined in the claims appended hereto.

Features and advantages of the circuit according to the invention will be apparent from the description below of an embodiment provided not restrictively by way of illustration, with reference to the appended drawings.

In these drawings:

- Figure 1 shows a diagram of an electronic ignition device for an internal combustion engine,

- Figures 2 and 3 show respective diagrams of the electrical signals present in the device in Figure 1 on the same time base,

- Figure 4 shows a block diagram of a circuit constructed according to the invention,

- Figure 5 shows a possible application of the circuit constructed according to the invention,

- Figure 6 shows an embodiment of the circuit in the block diagram illustrated in Figure 4,

- Figures 7 and 8 show the change in an output voltage of the circuit according to the invention.

With reference to these figures, 1 indicates as a whole a circuit for detecting an overvoltage in an electrical load Z1 inserted with a first and a second terminal between a feed line AL and a controlled switch S.

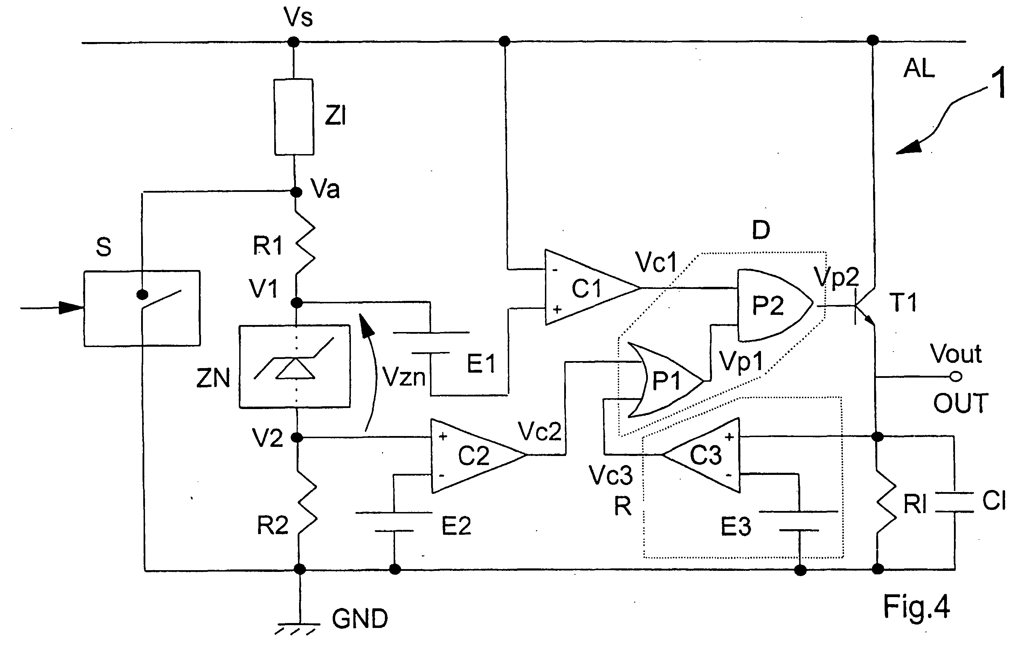

With particular reference to Figure 4, it will be noted that circuit 1 comprises a first threshold comparator C1 which has a first input terminal held at a first reference voltage E1, a second input terminal connected to feed line AL and an output terminal.

Again with reference to Figure 4, it will be noted that circuit 1 also includes a second threshold comparator C2 which has a first input terminal held at a second reference voltage E2.

This second comparator C2 also includes a second input terminal connected to the second terminal of electrical load Z1 through a one-way block ZN which is connected in series to a first resistance element R1, and an output terminal.

The second input terminal of comparator C2 is also connected to a fourth reference voltage GND, for example a ground, through a third resistance element R2.

Circuit 1 also includes an output transistor T1, for example of the NPN type, inserted with a first and a second terminal between feed line AL and an output terminal OUT from circuit 1.

This transistor T1 is controlled by means of a logic block D which has input connected to the output terminals of threshold comparators C1 and C2.

Circuit 1 also includes a feedback block R inserted with an input terminal and an output terminal respectively between the output terminal OUT of circuit 1 and a further input to logic block D.

More specifically, this feedback block R includes a third threshold comparator C3 which has a first input terminal held at a third reference voltage E3, a second input terminal connected to the output terminal OUT of circuit 1 and an output terminal.

In turn logic block D includes a first logic gate P1, for example of the OR type, which has a first input terminal connected to the output terminal of the second threshold comparator C2 and a second input terminal connected to the output terminal of the third threshold comparator C3.

In addition to this, logic block D also includes a second logic gate P2, for example of the AND type, having a first input terminal connected to the output terminal of first comparator C1 and a second input terminal connected to the output terminal of first logic gate P1.

This second logic gate P2 also includes an output terminal by means of which output transistor T1 is controlled.

Finally, Figure 4 shows that a condenser C1, which is connected in parallel to a second resistance element R1, is inserted between the output terminal OUT of circuit 1 and the fourth reference voltage GND.

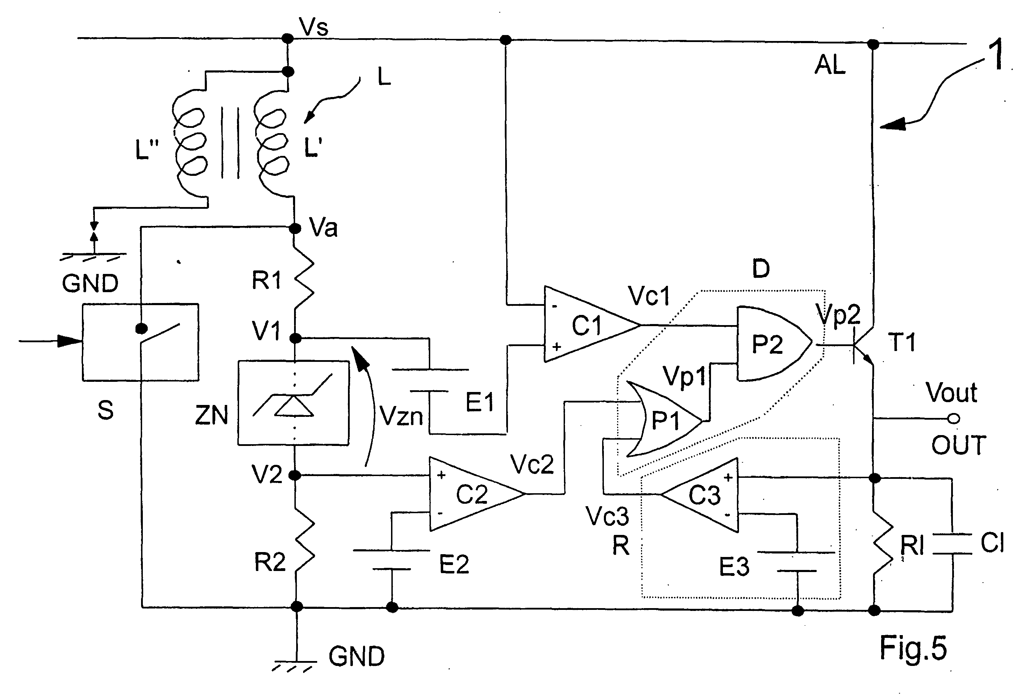

For convenience of description, the operation of circuit 1 according to the invention will now be described with reference to an application in which electrical load Z1 is of the inductive type, for example an engine's electronic ignition coil L comprising a primary circuit L' and a secondary circuit L", as shown in Figure 5.

An initial condition in which switch S is open will also be considered.

In this case it is found that a voltage Va, which changes as shown in Figures 2 and 3 according to whether a spark in the secondary circuit L" of the coil is absent or present, is present at the ends of primary circuit L' of ignition coil L.

The peak value of voltage Va is approximately 400 V if a spark is absent and approximately 250 V if a spark is present.

The case in which there is no spark in secondary circuit L" of coil L will first be considered assuming that a first condition obtains in which:

$$Va > Vzn + [R1 + R2] \times E2/R2 = Vth1 \qquad (1)$$

where Vzn is the voltage present at the terminals of one-way block ZN, which in this application is approximately 40V, with E2 of the order of 1 volt and Vth1 a first upper threshold value.

In addition to this, with the voltage at the terminals of the third resistance element R2 being V2, it follows from condition (1) that:

$$V2 > E2$$

It is also assumed that a second condition obtains in which:

$$V1 > Vs + E1 = Vth2 \qquad (2)$$

where $V1 = V2 + Vzn$, Vs is the supply voltage, which in this application is the same as the vehicle's battery voltage, and lies between approximately 6V and approximately 24V, E1 is of the order of a few volts and Vth2 is a second lower threshold value.

The existence of both conditions (1) and (2) implies that the first threshold comparator C1 and the second threshold comparator C2 perform a switching operation, providing their output terminals with a voltage Vc1 and Vc2, which are at a high logic level, respectively.

Voltage Vc2 activates logic gate P1 to provide an output voltage Vp1 which is itself at a high logic level.

As a consequence, because logic gate P2 has a high logic level on both its inputs it is activated to provide an output voltage Vp2 which is also at a high logic level.

This voltage Vp2 causes output transistor T1 to become active.

When this transistor becomes active, the OUT output terminal of circuit 1 has a voltage VOUT = Vp2-VbeT1 and condenser C1 begins to charge up.

It is also assumed that a third condition obtains in which:

$$Vout > E3 \qquad (3)$$

with E3 of the order of 1 volt.

The existence of this third condition implies that third threshold comparator C3 performs a switching operation, providing a voltage Vc3 at a high logic level as an output.

As a consequence, because logic gate P1 has both inputs at a high logic level it continues to maintain voltage Vp1 at a high logic level.

As a result of what has been described above, voltage Vout remains at the value Vp2-VbeT1 and condenser C1 remains charged.

If the current flowing through one-way block ZN is I, then:

$$Va = Vzn + (R1 + R2) \times I$$

With reference to Figure 5, when $Va \cong Vzn$, I is cancelled out and as a consequence Va becomes equal to V1.

In this situation then also $V2 = R2 \times I = 0$

However, if condition (2) is still fulfilled, and therefore:

$$V1 = Va > Vth2,$$

first threshold comparator C1 continues to maintain voltage Vc1 at a high logic level while second threshold comparator C2 performs a switching operation, reducing voltage Vc2 to zero.

As condenser C1 is charged to a voltage Vout > E3, third threshold comparator C3 maintains voltage Vc3 at a high logic level and there is still a voltage Vp1 at a high logic level at the output from logic gate P1.

In turn, as logic gate P2 still has inputs at a high logic level, it maintains voltage Vp2 at a high logic level, and as a consequence output transistor T1 remains active.

When it is then found that:

$$Va = V1 < Vth2$$

first threshold comparator C1 switches, reducing voltage Vc1 to zero.

As a consequence, logic gate P2 also switches, reducing voltage Vp2 to zero and deactivating output transistor T1.

In these circumstances the course of voltage Vout follows that of the discharge of condenser C1 to second resistance member R1.

More specifically, the course of voltage Vout is that shown in Figure 7. It should be pointed out that once voltage Vout has fallen below the value of reference voltage E3 it does not become positive again unless condition (1) is reestablished.

An identical method of functioning to that just described occurs when there is a spark in secondary circuit L" of ignition coil L.

In this case however there is a problem associated with the course of voltage Va.

As shown in Figure 3, after a first short-lived overvoltage of approximately 10 ms, voltage Va in fact undergoes a sequence of alternations from zero to approximately 70-80 V in rapid succession lasting a few tenths of a microsecond.

From what has been said above it follows that when Va < Vth2, output transistor T1 becomes deactivated and condenser C1 begins to discharge.

In order that this should not happen condenser C1 and second resistance element R1 have to be dimensioned so that condition Vout > E3 still obtains throughout the sequence of alternations to which voltage Va is subjected.

In this way, third comparator C3 in fact maintains voltage Vc3 at a high logic level.

It is then sufficient for voltage Va to rise above lower threshold value Vth2 in order for voltage Vc2 to be again at a high logic level.

In this way logic gate P2 is activated again to provide an output voltage Vp2 at a high logic level, which reactivates output transistor T1.

If there is a spark in secondary circuit L" of ignition coil L, the course of voltage Vout is therefore that shown in Figure 8.

Also, as shown in Figures 2 and 3, once the spark in secondary circuit L" of coil L has been exhausted, voltage Va shows a transient to zero and then stops at the supply voltage Vs, which is less than lower threshold voltage Vth2.

As a consequence, voltage Vout tends to zero over the discharge time of condenser C1 to second resistance element R1, as shown in Figures 7 and 8.

It should be pointed out that circuit 1 and controlled switch S, which is constructed for example using a power transistor, are incorporated into the same silicon chip using technology of the VIPower type.

This results in the filtering of voltage Va through condenser C1 being performed only at the output from circuit 1.

In fact, because of the alternation which voltage Va undergoes when a spark is present in secondary circuit L" of coil L, which causes it to adopt negative values with respect to ground, any filtering performed at an intermediate point in circuit 1 would be negated through the activation of spurious active components which would deactivate the circuit itself.

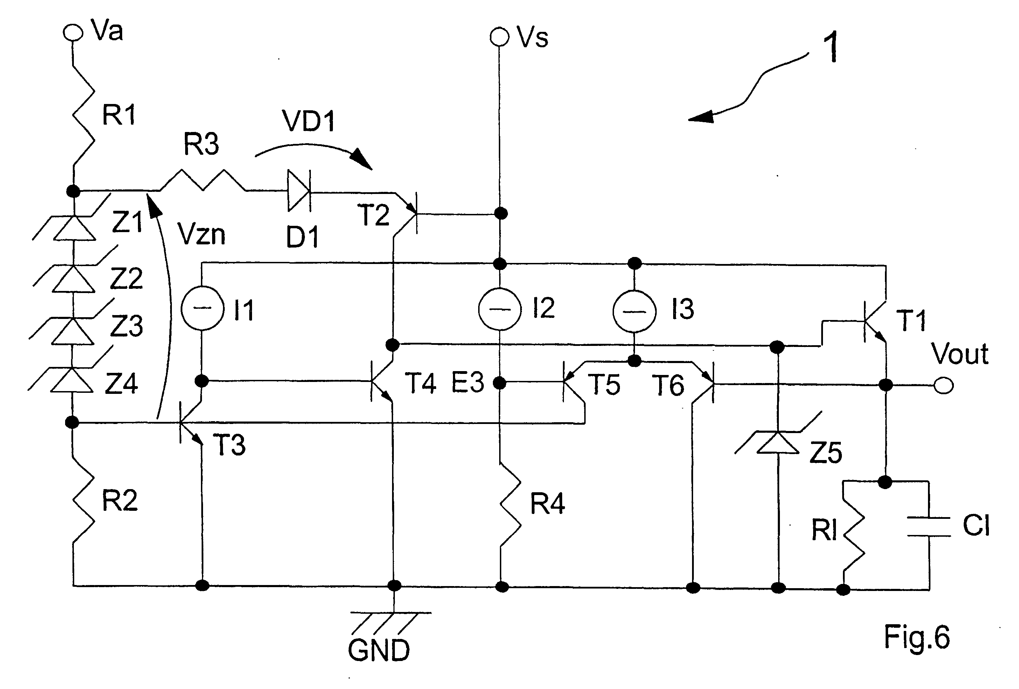

Figure 6 shows a preferred embodiment of circuit 1 according to the invention.

With reference to this figure, one-way block ZN comprises a first diode, Z1, a second Z2, a third Z3 and a fourth Z4, of the Zener, type which are connected together in series.

First threshold comparator C1 comprises a second transistor T2, of the PNP type, while second threshold comparator C2 and first logic gate P1 are provided by a third transistor T3, of the NPN type.

A fifth diode D1 is connected to an emitter terminal of second transistor T2 to provide first reference voltage E1.

Figure 6 also shows that second logic gate P2 is provided by a fourth transistor T4, of the NPN type, while a fifth transistor T5 and a sixth T6, of the PNP type, in a mirror-current connection, provide third threshold comparator C3.

In addition to this, circuit 1 as shown in Figure 6 also comprises a sixth diode Z5 of the Zener type, inserted with a first and a second terminal between a drive terminal first output transistor T1 and a ground.

As far as the functioning of the embodiment of the circuit just described is concerned, when voltage Va is less than voltage Vzn present at the ends of the chain of Zener diodes Z1, Z2, Z3, Z4, third transistor T3 is deactivated while fourth transistor T4 is activated and keeps first output transistor T1 deactivated.

As a consequence voltage Vout is equal to zero.

When on the other hand voltage Va rises above voltage Vzn, current I which flows in the chain of Zener diodes Z1, Z2, Z3, Z4 activates third transistor T3 which causes fourth transistor T4 to be deactivated.

At the same time, second transistor T2 also becomes active providing an output current which causes first transistor T1 to become active.

When this transistor becomes active, voltage Vout rises to a value which is greater than zero.

It should be pointed out that the existence of diode Z5 causes voltage Vout not to exceed a maximum value of Vz5-VbeT1.

In addition to this, if the condition:

$$Vout > E3$$

obtains, the comparator formed by fifth transistor T5 and sixth T6 switches, causing T6 to be deactivated and T5 to be activated, keeping third transistor T3 active.

The latter continues to keep fourth transistor T4 inactive.

When voltage Va again falls below voltage Vzn, current I flowing in the chain of Zener diodes Z1, Z2, Z3, Z4 becomes equal to zero.

However, if the condition:

$$Va > Vs + VbeT2 + VD1$$

obtains, second transistor T2 continues to remain active, keeping first transistor T1 activated.

If on the other hand:

$$Va < Vs + VbeT2 + VD1$$

obtains, second transistor T2 is deactivated, and no longer provides any current to first transistor T1, which is in turn deactivated.

As a consequence voltage Vout begins to fall in accordance with the discharge function for condenser C1 to second resistance member R1.

However, as long as:

$$Vout > E3$$

fifth transistor T5 continues to remain active, keeping third transistor T3 active.

In turn, third transistor T3 keeps fourth transistor T4 inactive.

In these circumstances it is then sufficient for voltage Va to rise above the threshold value Vs + Vd1 + VbeT2 in order to again activate second transistor T2, which causes first transistor T1 to become activated.

In this way voltage Vout again adopts a value which is greater than zero.

When however voltage Va falls below the threshold value for a sufficiently long time to allow voltage Vout to fall below reference voltage E3, then sixth transistor T6 becomes active and fifth transistor T5 becomes inactive.

As a consequence, third transistor T3 also becomes inactive, while fourth transistor T4 becomes active, rendering first transistor T1 definitively inactive.

The latter can only be made active again when voltage Va again exceeds voltage Vzn, reactivating the chain of Zener diodes Z1, Z2, Z3, Z4.

At this point the cycle which has just been described is repeated.

**Claims**

1. A circuit for detecting a time duration of an overvoltage signal (Va) on an electrical load (Z1) inserted with first and second terminals between a feed line (AL) and a control switch (S), said circuit having an output voltage signal (Vout) at an output terminal (OUT) and comprising:

   - at least one first threshold comparator (C1) having a first input terminal receiving a voltage indicative of the overvoltage (Va), said voltage including a first reference voltage (E1) applied to said first input terminal, a second input terminal coupled to the feed line (AL) and an output terminals for producing a first voltage signal (Vc1) at a first logic level when the overvoltage signal (Va) exceeds a second threshold voltage (Vth2) and at a second logic level when the overvoltage signal (Va) falls below a second threshold voltage (Vth2),

   - at least one second threshold comparator (C2) having a first input terminal held at a second reference voltage (E2), a second input terminal receiving a voltage indicative of the overvoltage (Va), and an output terminal for producing a second voltage signal (Vc2) at a first logic level when the overvoltage signal (Va) exceeds a first threshold voltage (Vth1) and at a second logic level when the overvoltage signal (Va) falls below the first threshold voltage (Vth1),

   - at least one output transistor (T1) inserted with first and second terminals between the feed line (AL) and the output terminal (OUT) for producing the output voltage signal (Vout), said transistor (T1) being connected to at least one logic block (D) having inputs connected to the outputs of threshold comparators (C1) and (C2), said logic block (D) being for controlling the output transistor (T1) so as to have the output voltage signal (Vout) at the first logic level when the first (Vc1) and the second (Vc2) voltage signal are at the first logic level,

   - at least one feedback block (R) inserted with an input terminal and an output terminal respectively between the output terminal (OUT) and a further input terminal to the logic block (D), said feedback block (R) being for maintaining the output voltage signal (Vout) at the first logic level for a time interval sufficient to suppress changes in said logic level due to rapid changes of the overvoltage (Va), said time duration being detected by the condition Va<Vth2 persisting for a sufficient long time in order to distinguish between rapid changes and regular overvoltage duration during the time duration of the overvoltage signal (Va).

2. A circuit according to claim 1, **characterised in that** the feedback block (R) includes at least a third threshold comparator (C3) having a first input terminal held at a third reference voltage (E3), a second input terminal connected to the output (OUT) terminal from circuit (1) and an output terminal.

3. A circuit according to claim 1, **characterised in that** the logic block (D) comprises:

   - at least one first logic gate (P1) having a first input terminal connected to the output terminal of the second threshold comparator (C2), a second input terminal connected to the output terminal from the third threshold comparator (C3) and an output terminal,

   - at least one second logic gate (P2) having a first input terminal connected to the output terminal from the first comparator (C1), a second input terminal connected to the output terminal from the first logic gate (P1) and an output terminal capable of controlling the output transistor (T1).

4. A circuit according to claim 1, **characterised in that** the second input terminal to the second comparator (C2) is connected to the second terminal of the electric load (Z1) through at least one one-way block (ZN) connected in series to a first resistance element (R1).

5. A circuit according to claim 1, **characterised in that** a condenser (C1) connected in parallel to a second resistance element (R1) is inserted between its output terminal (OUT) and a fourth reference voltage (GND).

6. A circuit according to claim 3, **characterised in that** the first logic gate (P1) is of the OR type.

7. A circuit according to claim 3, **characterised in that** the second logic gate (P2) is of the AND type.

8. A circuit according to claim 1, **characterised in that** the output transistor (T1) is of the NPN type.

9. A circuit according to claim 1, **characterised in that** it is integrated using technology of the VIPower type.

**Patentansprüche**

1. Schaltung zum Erfassen der Zeitdauer eines Überspannungssignals (Va) an einer elektrischen Last (Z1), die mit einem ersten und einem zweiten Anschluss zwischen einer Speiserleitung (Al) und einem Steuerschalter (S) liegt, wobei die Schaltung an einem Ausgangsanschluss (Out) ein Ausgangsspannungssignal (Vout) aufweist, umfassend:

   - mindestens einen ersten Schwellenwertvergleicher (C1) mit einem ersten Eingangsanschluss, der eine für die Überspannung (Va) kennzeichnende Spannung empfängt, welche eine erste Referenzspannung (E1) enthält, die an den ersten Eingangsanschluss gelegt wird, mit einem zweiten Eingangsanschluss, der mit der Speiserleitung (Al) gekoppelt ist, und einem Ausgangsanschluss zum Erzeugen eines ersten Spannungssignals (Vt1) auf einem ersten logischen Pegel, wenn das Überspannungssignal (Va) eine zweite Schwellenspannung (Vth2) übersteigt, und auf einem zweiten logischen Pegel, wenn das Überspannungssignal (Va) unter eine zweite Schwellenspannung (Vth2) abfällt,

   - mindestens einen zweiten Schwellenwertvergleicher (C2) mit einem ersten Eingangsanschluss, der auf einer zweiten Referenzspannung (E2) gehalten wird, mit einem zweiten Eingangsanschluss, der eine für die Überspannung (Va) kennzeichnende Spannung empfängt, und mit einem Ausgangsanschluss zum Erzeugen eines zweiten Spannungssignals (Vc2) auf einem ersten logischen Pegel, wenn das Überspannungssignal (Va) eine erste Schwellenspannung (Vth1) übersteigt, und auf einem zweiten logischen Pegel, wenn das Überspannungssignal (Va) unter die erste Schwellenspannung (Vth1) fällt,

   - mindestens einen Ausgangstransistor (T1), der mit einem ersten und einem zweiten Anschluss zwischen die Speiserleitung (Al) und den Ausgangsanschluss (OUT) gelegt ist, um das Ausgangsspannungssignal (Vout) zu erzeugen, wobei der erste Transistor (T1) an mindestens einen Logikblock (D) angeschlossen ist, dessen Eingänge an die Ausgänge der Schwellenwertvergleicher (C1 und C2) angeschlossen sind, wobei der Logikblock (D) dazu dient, den Ausgangstransistor (T1) so zu steuern, dass das Ausgangsspannungssignal (Vout) auf dem ersten logischen Pegel liegt, wenn das erste (Vc1) und das zweite (Vc2) Spannungssignal den ersten logischen Pegel aufweisen,

- mindestens einen Rückkopplungsblock (R), der mit einem Eingangsanschluss und einem Ausgangsanschluss zwischen den Ausgangsanschluss (OUT) bzw. einen weiteren Eingangsanschluss des Logikblocks (D) geschaltet ist, wobei der Rückkopplungsblock (R) dazu dient, das Ausgangsspannungssignal (Vout) auf einem ersten logischen Pegel für ein Zeitintervall zu halten, welches ausreicht, Änderungen des logischen Pegels aufgrund rascher Änderungen der Überspannung (Va) zu unterdrücken, wobei die Zeitspanne erfasst wird durch den Zustand Va<Vth2, der für eine ausreichend lange Zeitspanne anhält, um unterscheiden zu können zwischen raschen Änderungen und regulärer Überspannungsdauer während der Zeitspanne des Überspannungssignals (Va).

2. Schaltung nach Anspruch 1, **dadurch gekennzeichnet, dass** der Rückkopplungsblock (R) mindestens einen dritten Schwellenwertvergleicher (C3) aufweist, der mit einem ersten Eingangsanschluss auf einer dritten Referenzspannung (E3) gehalten wird, und der mit einem zweiten Eingangsanschluss an dem Ausgang (OUT) der Schaltung (1) angeschlossen ist, und der einen Ausgangsanschluss besitzt.

3. Schaltung nach Anspruch 1, **dadurch gekennzeichnet, dass** der Logikblock (D) aufweist:

   - mindestens ein erstes logisches Gatter (P1) mit einem ersten Eingangsanschluss am Ausgangsanschluss des zweiten Schwellenwertvergleichers (C2), mit einem zweiten Eingangsanschluss am Ausgangsanschluss des dritten Schwellenwertvergleichers (C3) und mit einem Ausgangsanschluss,
   - mindestens ein zweites logisches Gatter (P2), welches mit einem ersten Eingangsanschluss an den Ausgangsanschluss des ersten Vergleichers (C1) angeschlossen ist, mit einem zweiten Eingangsanschluss an den Ausgang des ersten logischen Gatters (P1) angeschlossen ist, und mit einem Ausgangsanschluss den Ausgangstransistor (T1) steuern kann.

4. Schaltung nach Anspruch 1, **dadurch gekennzeichnet, dass** der zweite Eingangsanschluss des zweiten Vergleichers (C2) an den zweiten Anschluss der elektrischen Last (Z1) über mindestens einen Einwegblock (ZN) angeschlossen ist, der in Reihe zu einem ersten Widerstandselement (R1) liegt.

5. Schaltung nach Anspruch 1, **dadurch gekennzeichnet, dass** ein parallel zu einem zweiten Widerstandselement (R2) liegender Kondensator (C1) zwischen ihren Ausgangsanschluss (OUT) und eine vierte Referenzspannung (GND) geschaltet ist.

6. Schaltung nach Anspruch 3, **dadurch gekennzeichnet, dass** das erste logische Gatter (P1) vom ODER-Typ ist.

7. Schaltung nach Anspruch 3, **dadurch gekennzeichnet, dass** das zweite logische Gatter (P2) vom UND-Typ ist.

8. Schaltung nach Anspruch 1, **dadurch gekennzeichnet, dass** der Ausgangstransistor (T1) vom NPN-Typ ist.

9. Schaltung nach Anspruch 1, **dadurch gekennzeichnet, dass** die Schaltung mittels VIPower-Technologie integriert ist.

## Revendications

1. Circuit de détection de la durée de temps d'un signal de surtension (Va) sur une charge électrique (Z1) inséré, avec des première et deuxième bornes, entre une ligne d'alimentation (AL) et un interrupteur de commande (S), ledit circuit ayant un signal de tension en sortie (Vout) à une borne de sortie (OUT) et comprenant :

   - au moins un premier comparateur à seuil (C1) ayant une première borne d'entrée recevant une tension indicative de la surtension (Va), ladite tension comprenant une première tension de référence (E1) appliquée à ladite première borne d'entrée, une deuxième borne d'entrée couplée à la ligne d'alimentation (AL) et une borne de sortie pour produire un premier signal de tension (Vc1) à un premier niveau logique, lorsque le signal de surtension (Va) dépasse une deuxième tension de seuil (Vth2), et à un deuxième niveau logique, lorsque le signal de surtension (Va) chute au-dessous de la deuxième tension de seuil (Vth2) ;
   - au moins un deuxième comparateur à seuil (C2) ayant une première borne d'entrée maintenue à une deuxième tension de référence (E2), une deuxième borne d'entrée recevant une tension indicative de la surtension (Va) et une borne de sortie pour produire un deuxième signal de tension (Vc2) à un premier niveau logique, lorsque le signal de surtension (Va) dépasse une première tension de seuil (Vth1), et à un deuxième niveau logique, lorsque le signal de surtension (Va) chute au-dessous de la première tension de seuil (Vth1) ;

- au moins un transistor de sortie (T1) inséré, avec des première et deuxième bornes, entre une ligne d'alimentation (AL) et la borne de sortie (OUT) pour produire le signal de tension en sortie (Vout), ledit transistor (T1) étant connecté à au moins un bloc logique (D) comportant des entrées connectées aux sorties des comparateurs à seuil (C1) et (C2), ledit bloc logique (D) servant à commander le transistor de sortie (T1) de manière à faire en sorte que le signal de tension en sortie (Vout) soit au premier niveau logique, lorsque le premier (Vc1) et le deuxième (Vc2) signal de tension sont au premier niveau logique ;

- au moins un bloc de rétroaction (R) inséré, avec une borne d'entrée et une borne de sortie, respectivement entre la borne de sortie (OUT) et une autre borne d'entrée du bloc logique (D), ledit bloc de rétroaction (R) servant à maintenir le signal de tension en sortie (Vout) au premier niveau logique, pendant un intervalle de temps suffisant pour supprimer des variations dudit niveau logique, qui seraient dues à des variations rapides de la surtension (Va), ladite durée de temps étant détectée par la condition Va < Vth2 persistant pendant un temps suffisamment long pour effectuer une distinction entre des variations rapides et une durée de surtension régulière, au cours de la durée de temps du signal de surtension (Va).

2. Circuit selon la revendication 1, **caractérisé en ce que** le bloc de rétroaction (R) comprend au moins un troisième comparateur à seuil (C3) ayant une première borne d'entrée maintenue à une troisième tension de référence (E3), une deuxième borne d'entrée connectée à la borne de sortie (OUT) du circuit (1) et une borne de sortie.

3. Circuit selon la revendication 1, **caractérisé en ce que** le bloc logique (D) comprend :

- au moins une première porte logique (P1) ayant une première borne d'entrée connectée à la borne de sortie du deuxième comparateur à seuil (C2), une deuxième borne d'entrée connectée à la borne de sortie du troisième comparateur à seuil (C3) et une borne de sortie ;

- au moins une deuxième porte logique (P2) ayant une première borne d'entrée connectée à la borne de sortie du premier comparateur (C1), une deuxième borne d'entrée connectée à la borne de sortie de la première porte logique (P1) et une borne de sortie susceptible de commander le transistor de sortie (T1).

4. Circuit selon la revendication 1, **caractérisé en ce**

**que** la deuxième borne d'entrée du deuxième comparateur (C2) est connectée à la deuxième borne de la charge électrique (Z1) par l'intermédiaire d'au moins un bloc unidirectionnel (ZN) connecté en série à un premier élément de résistance (R1).

5. Circuit selon la revendication 1, **caractérisé en ce qu'**un condensateur (C1), connecté en parallèle à un deuxième élément de résistance (R1), est inséré entre sa borne de sortie (OUT) et une quatrième tension de référence (GND).

6. Circuit selon la revendication 3, **caractérisé en ce que** la première porte logique (P1) est de type OU.

7. Circuit selon la revendication 3, **caractérisé en ce que** la deuxième porte logique (P2) est de type ET.

8. Circuit selon la revendication 1, **caractérisé en ce que** le transistor de sortie (T1) est de type NPN.

9. Circuit selon la revendication 1, **caractérisé en ce qu'**il est intégré en utilisant une technologie de type VIP de puissance.

Fig.1

FIG.2

FIG.7

Va

Vth1

Vth2

Vs

t

Vout

t

Va

Vth1

Vth2

Vs

FIG.3

t

Vout

FIG.8

t

Fig.4

Fig.5

EP 0 740 073 B1

Fig.6